# EUROPÄISCHE PATENTSCHRIFT

(11) **EP 0 596 975 B1**
(45) Veröffentlichungstag und Bekanntmachung des Hinweises auf die Patenterteilung: **06.12.1995**
(21) Anmeldenummer: 92916425.9
(22) Anmeldetag: 20.07.1992
(51) Int. Cl.: H01L 29/78, H01L 27/10

(54) **KOMPAKTE HALBLEITERSPEICHERANORDNUNG UND VERFAHREN ZU DEREN HERSTELLUNG**
COMPACT SEMICONDUCTOR STORE ARRANGEMENT AND PROCESS FOR ITS PRODUCTION
AGENCEMENT COMPACT DE MEMOIRES A SEMI-CONDUCTEURS ET SON PROCEDE DE FABRICATION

(30) Priorität: 30.07.1991 DE 4125199
(43) Veröffentlichungstag der Anmeldung: 18.05.1994
(73) Patentinhaber: SIEMENS AKTIENGESELLSCHAFT, 80333 München (DE)
(72) Erfinder: MELZNER, Hanno, Dipl.-Phys., D-85665 Grosshelfendorf (DE)
(86) Internationale Anmeldenummer: EP9201653
(87) Internationale Veröffentlichungsnummer: WO9303501

(56) Entgegenhaltungen:
- EP-A- 0 176 254
- US-A- 4 912 535
- US-A- 4 918 500
- US-A- 4 984 696
- IEEE Circuits And Devices Magazine, Vol. 5, Nr. 1, Januar 1989, Nicky C.C. LU : "Advanced Cell Structures for Dynamic RAMs", page 31, lines 4-36

## Beschreibung

Die Erfindung betrifft eine Halbleiterspeicheranordnung in einem Halbleitersubstrat mit Speicherzellen, jeweils bestehend aus einem Kondensator und einem MOS-Auswahltransistor.

Halbleiterspeicher bestehen aus einer Anzahl von Speicherzellen in einem z.B. aus Silizium bestehenden Halbleitersubstrat, die sich jeweils aus einem Kondensator zur Speicherung der Information und einem Transistor zur Auswahl des bestimmten Kondensators zusammensetzen. Um eine geringe Zugriffszeit und benötigte Fläche bei hohem Speicherangebot zu erreichen, muß die Integrationsdichte der Anordnung erhöht werden, d. h. der Platzbedarf einer Zelle muß minimiert werden. Eine lineare Verkleinerung aller Strukturen der Zelle ist jedoch nicht möglich, da beispielsweise der Kondensator aus Gründen der elektrischen Zuverlässigkeit eine bestimmte Kapazität nicht unterschreiten darf und beliebig feine Strukturen mit den zur Verfügung stehenden Techniken nicht erzeugt werden können. Stattdessen muß bei einer gegebenen Strukturfeinheit eine möglichst kleine Zelle erreicht werden, d. h. das Ziel ist eine möglichst kompakte Zelle. Ein Maß dafür, inwieweit eine Speicheranordnung diesem Ziel entspricht, ist die Größe c: = Zellfläche/(minimale Strukturgröße)²; c soll also möglichst klein werden.

Wird c kleiner als acht, so verhindern die zur Ansteuerung eines Transistors notwendigen Wortleitungen und Bitleitungen eine weitere Verkleinerung der Zelle, solange nur an jeder zweiten Kreuzung von Wort- und Bitleitung eine Zelle plaziert ist. Dies ist beim fast ausnahmslos verwendeten sogenannten folded-bitline-Schema der Fall. Bei Werten von c kleiner als acht wird es erforderlich, an jeder Kreuzung von Wort- und Bitleitung eine Zelle zu plazieren (sog. open-bitline Konzept). Bei dieser Beschaltung kann jedoch nicht - wie beim folded-bitline-Schema - beim Auslesen einer Zelle eine Vergleichsmessung zweier benachbarter Bitleitungen durchgeführt werden, so daß bei Speicheranordnungen nach dem open-bitline-Konzept die Bewertungssicherheit im allgemeinen geringer ist.

Zur Erzeugung einer möglichst kleinen Zelle ist beispielsweise aus EP-A 0 176 254 bekannt, den Kondensator in einem Graben im Halbleitersubstrat anzuordnen, wobei beide Elektroden des Kondensators in Form von leitenden Schichten und isoliert vom Halbleitersubstrat im Graben untergebracht werden. Eine solche Speicherzelle wird durch einen in der US-PS 4 918 500 vorgeschlagenen Seitenwandkontakt noch kompakter: Der Anschluß der ersten Kondensatorelektroden an ein leitenoes Gebiet des Auswahltransistors erfolgt nicht an der Oberfläche des Halbleitersubstrats, sondern an der Grabenwand, indem eine die Grabenwand bedeckende Schicht, die die erste Elektrode vom Halbleitersubstrat isoliert, an einer Stelle in der Nähe der Grabenoberkante entfernt wird. Weitere Konzepte für höchstintegrierte Halbleiterspeicheranordnungen werden in dem Artikel von N. Lu in IEEE Circuits and Devices Magazine, Januar 1989, Seiten 27 bis 36 diskutiert.

Aufgabe der vorliegenden Erfindung ist es, eine Halbleiterspeicheranordnung anzugeben, welche die erläuterten Probleme löst.

Diese Aufgabe wird durch eine Anordnung gemäß Patentanspruch 1 oder 15 und ein Verfahren gemäß Patentanspruch 10 gelöst. Weiterbildungen der Erfindung sind Gegenstand von Unteransprüchen.

Die Erfindung beruht auf
- einer selbstjustierten Technik zur Erzeugung des Kondensatorgrabens, wodurch die sonst üblichen Abstände zwischen Graben und Transistor und zwischen Graben und lateraler Isolation entfallen,
- einem vertikalen Kontakt zwischen Bitleitung und einem leitenden Gebiet des Auswahltransistors, der an der Grabenwand angeordnet ist,
- einer speziellen Anordnung der Wortleitungen unter Verwendung von primären, sekundären und tertiären Wortleitungen, wodurch eine dem folded-bitline-Schema vergleichbare Bewertungssicherheit erreicht wird.

Die vorgeschlagene Zelle weist den Wert c = 6 auf und bietet für eine weitere Verkleinerung optimale Voraussetzungen. Sie ist für höchstintegrierte Halbleiterspeicher wie den 64M-DRAM einsetzbar.

Die Erfindung wird nachfolgend anhand eines in den Zeichnungen dargestellten Ausführungsbeispieles näher beschrieben. Es zeigen:
- Figur 1: eine Aufsicht auf und
- Figur 2 bis 7: einen Querschnitt durch ein Halbleitersubstrat im Bereich von Speicherzellen in schematischer Darstellung, an dem die Schritte einer Ausführungsform des Verfahrens verdeutlicht werden, wobei der Schnitt entlang der Linie II-II in Figur 1 verläuft.
- Figur 8: zeigt eine Aufsicht auf die Speichermatrix mit einer vorteilhaften Anordnung der Speicherzellen,
- Figur 9: zeigt eine Aufsicht auf die Speicheranordnung mit einer vorteilhaften Anordnung von Wortleitungen.

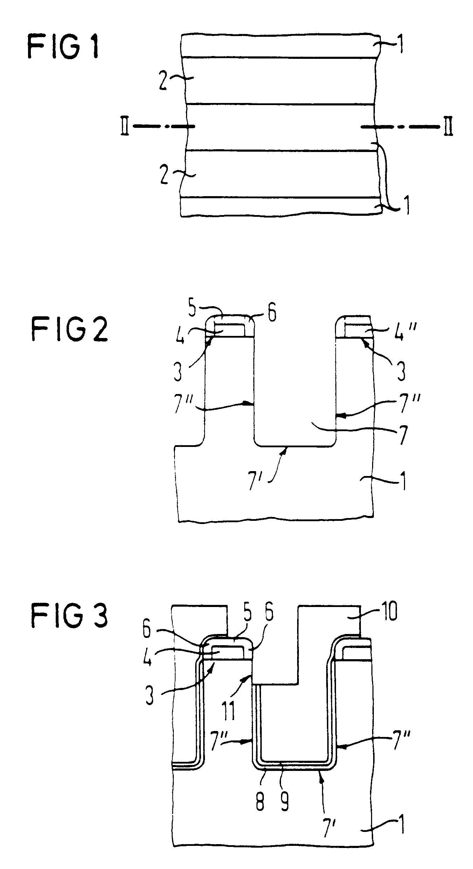

Figur 1: In einem Halbleitersubstrat 1 werden Isolationsgebiete 2 erzeugt, die im wesentlichen streifenförmig verlaufen und der lateralen Isolation der zwischen diesen Isolationsgebieten 2 herzustellenden Speicherzellen dienen. Vorzugsweise werden die Isolationsgebiete 2 als vergrabene Oxid-Gebiete, beispielsweise nach dem in dem Artikel von C. Zeller, F. Stelz, Tagungsband ESSDERC 89, Seiten 135 - 138 beschriebenen Verfahren erzeugt, so daß sie bei einer Tiefe von etwa 600 nm im wesentlichen vertikale Flanken aufweisen und ihre Oberflächen in einer Ebene mit der Oberfläche des Halbleitersubstrats 1 liegen.

Figur 2: Auf der gesamten Oberfläche 3 des Halbleitersubstrats 1 wird ein Gateoxid (nicht dargestellt) erzeugt, anschließend wird ganzflächig eine Schicht zur Bildung eines Gates 4 des Auswahltransistors und einer primären Wortleitung (4′) abgeschieden, beispielsweise dotiertes Polysilizium von etwa 250 nm Dicke. Darauf wird eine Isolationsschicht 5 vorzugsweise durch pyrolitische Zersetzung von Tetraethylorthosilikat (TEOS) abgeschieden (im folgenden als TEOS-Schicht 5 bezeichnet) und mit Hilfe einer Fototechnik zu einer Bahn strukturiert. Mit der strukturierten TEOS-Schicht 5 als Maske wird die Polysilizium-Schicht strukturiert, so daß eine etwa senkrecht zu den streifenförmigen Isolationsgebieten 2 verlaufende primäre Wortleitung (4′) erzeugt wird; dabei stellt ein über dem Halbleitersubstrat 1 verlaufender Teil gleichzeitig das Gate 4 dar. Es wird ein Ätzprozeß mit einer genügend hohen Selektivität zum Gateoxid und zum vergrabenen Oxid 2 eingesetzt. Die primäre Wortleitung und das Gate 4 werden zur Isolierung seitlich mit Spacern 6 eingekapselt, die üblicherweise durch eine weitere TEOS-Abscheidung von etwa 100 nm und einen anisotropen Rückätzprozeß hergestellt werden; die Oberfläche von Wortleitung und Gate 4 sind bereits mit TEOS 5 abgedeckt.

Mit Hilfe weiterer Fototechniken werden nun leitende Gebiete (Source und Drain) der Transistoren implantiert, insbesondere der Transistoren in der Peripherie der Schaltung. Die leitenden Gebiete des Auswahltransistors können auch in einem späteren Verfahrensschritt erzeugt werden.

Für die vorstehend beschriebenen Verfahrensschritte können Prozesse eingesetzt werden, die in der Halbleitertechnologie üblich sind. So ist beispielsweise bekannt, zur Erzielung einer kurzen Gatelänge die Breite der TEOS-Bahn 5 durch eine Naßätzung vor der Strukturierung der Polysilizium-Schicht unter die von der Fototechnik gesetzte Grenze zu verringern. Üblich ist ferner ein Oxidationsschritt zur Verrundung der unteren Gatekanten.

Die Erfindung sieht nun vor, einen Kondensatorgraben 7 selbstjustiert zu den bereits erzeugten Strukturen, d.h. zu den Isolationsgebieten 2 sowie zu den mit der TEOS-Schicht 5 und den Spacern 6 eingekapselten primären Wortleitungen bzw. Gates 4 (mit 4˝ ist ein benachbartes Gate bezeichnet), in dem Halbleitersubstrat 1 herzustellen. Es wird ein anisotroper Atzprozeß eingesetzt, der das Material der erwähnten Strukturen, nämlich Siliziumdioxid und TEOS, in ausreichendem Maße langsamer ätzt als das freiliegende Halbleitersubstrat 1. Die TEOS-Schicht 5 und die Spacer 6 müssen nach dem Ätzprozeß noch eine ausreichende Isolation darstellen. Der so hergestellte Graben 7 zur Aufnahme des Kondensators hat einen im wesentlichen rechteckigen Querschnitt.

Figur 3: Zur Isolation gegenüber dem Halbleitersubstrat 1 wird auf die Oberfläche des Grabens 7, die aus einem Boden 7′ und einer zur Halbleitersubstrat-Oberfläche 3 im wesentlichen senkrechten Wand 7˝ besteht, eine erste isolierende Schicht 8,9 aufgebracht. In diesem Ausführungsbeispiel besteht die erste isolierende Schicht aus einer Doppelschicht mit einer ca. 20 nm dicken Siliziumoxid-Schicht 8 und einer ganzflächig abgeschiedenen, ca. 30 nm dicken Siliziumnitrid-Schicht 9 als Komponenten. Eine strukturierte Fotolackschicht 10 legt eine Seite der Grabenwand 7˝ in der Nähe der Grabenoberkante bis in eine bestimmte, über die Belichtungszeit bei der Strukturierung einstellbare Tiefe frei. Mindestens die gegenüberliegende Seite der Grabenwand 7˝ und der Boden sind mit Lack 10 bedeckt. Die erste isolierende Schicht 8,9 wird an der freiliegenden Stelle entfernt, so daß eine erste Öffnung in der ersten isolierenden Schicht 8,9 gebildet wird; dabei darf das TEOS 5,6 der Gate-Einkapselung nur geringfügig angegriffen werden. Die nun freiliegende Stelle des Halbleitersubstrats 1 im oberen Bereich der Grabenwand 7˝ ermöglicht einen späteren Kontakt zwischen einer Kondensatorelektrode und einem leitenden Gebiet des Auswahltransistors und stellt den sogenannten Grabenkontakt 11 dar. Er definiert den zum Graben 7 zugehörigen Auswahltransistor, der in der Figur 3 auf der linken Seite des Grabens liegt.

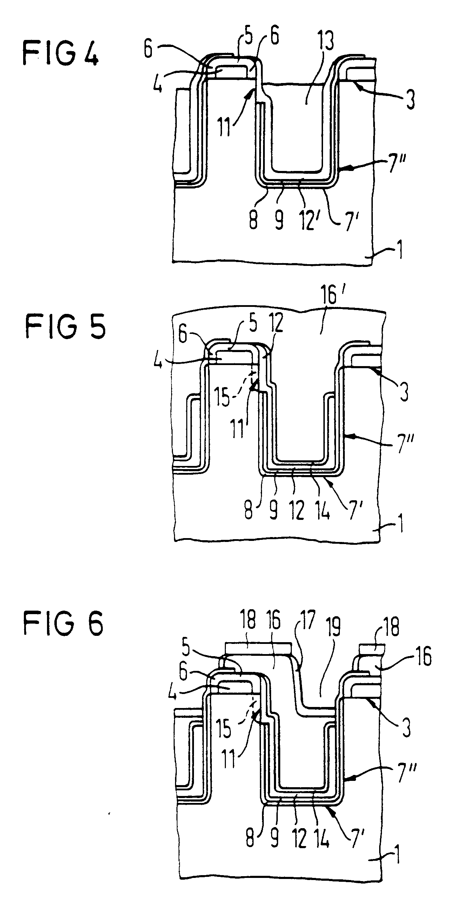

Figur 4: Die strukturierte Fotolackschicht 10 wird entfernt. Zur Bildung einer ersten Elektrode 12 des Kondensators wird eine erste Elektrodenschicht 12′ hergestellt. Dazu kann beispielsweise eine etwa 30 nm dicke dotierte Polysilizium-Schicht abgeschieden werden, die anschließend durch eine anisotrope Rückätzung mindestens oberhalb der TEOS-Bahn 5 entfernt wird. Hierdurch wird die erste Elektrodenschicht 12′ erzeugt, aus der später die erste Elektrode 12 gebildet wird. Bei der Rückätzung kann der Graben 7 teilweise mit einem Lackstöpsel 13 aufgefüllt werden, welcher die durch die unterliegende erste isolierende Schicht 8,9 erzeugte Stufe in der ersten Elektrodenschicht 12′ am Grabenkontakt 11 bedeckt. Dadurch wird die erste Elektrodenschicht 12′ an dieser Stufe nicht angegriffen und bedeckt außerdem auch den Grabenboden 7′. Der Lackstöpsel 13 kann beispielsweise mit einer Lackrückbelichtung (d. h. ganzflächige Belichtung und Entwickeln) in den Graben gebracht werden; nach der Rückätzung wird er entfernt. Die so hergestellte erste Elektrodenschicht 12′ ist noch mit der ersten Elektrodenschicht in einem in Richtung der primären Wortleitung (4′) benachbarten Graben verbunden, und zwar über den oberhalb der Substratoberfläche 3, seitlich am TEOS-Spacer 6 liegenden Teil der ersten Elektrodenschicht 12′.

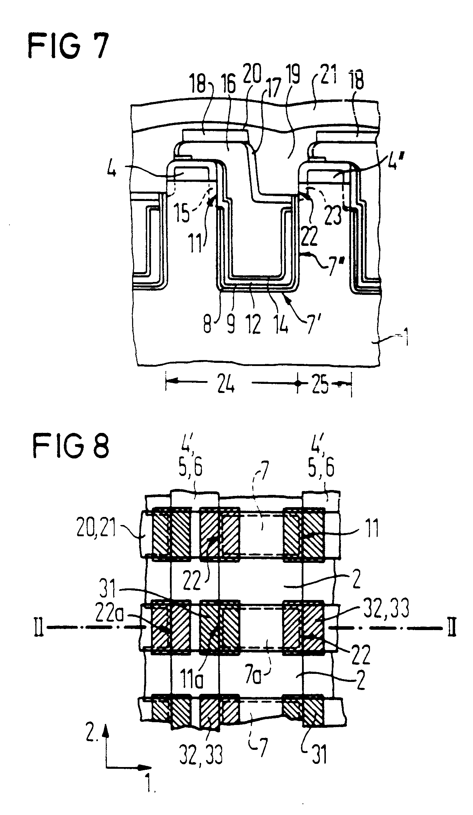

Figur 5: Mit Hilfe einer Fototechnik wird die erste Elektrodenschicht 12′ so strukturiert, daß in jedem Graben eine erste Elektrode 12 liegt. Aufgrund der erfindungsgemäßen Speichermatrix kann dies einfach durchgeführt werden: Die (nicht dargestellte) Fototechnik definiert auf der der ersten Öffnung (dem Grabenkontakt 11) gegenüberliegenden Seite der Grabenwand 7˝ in der Nähe der Grabenoberkante eine zweite Öffnung. An dieser Stelle wird die erste Elektrodenschicht 12′ selektiv zur unterliegenden ersten isolierenden Schicht 8,9 entfernt und besitzt so die zweite Öffnung. Die Seite der Grabenwand 7˝, an welcher die erste Öffnung angeordnet ist, ist während dieses Prozeßschritts mit Fotolack bedeckt. Um die Trennung von den erwähnten benachbarten ersten Elektroden zu gewährleisten, muß die zweite Öffnung in Wortleitungsrichtung mindestens die in Figur 8 dargestellten Ausmaße (32) aufweisen, d. h. den gesamten Graben beidseitig bis zu den Isolationsgebieten 2 überdecken; in der dazu senkrechten Richtung muß die vollständige Entfernung der ersten Elektrodenschicht 12′ oberhalb der Substratoberfläche 3 und auch in der Nähe der Grabenoberkante sichergestellt sein. Aufgrund verfahrenstechnischer Randbedingungen, insbesondere Auflösungsvermögen und Justierfehler bei der Fototechnik, muß das in Figur 8 mit 32 bezeichnete Gebiet i.a. größer gewählt werden. Die zweite Öffnung in der ersten Elektrodenschicht 12′ reicht vorteilhafterweise bis zu einer Tiefe von etwa 500 nm unterhalb der Substratoberfläche 3, dies kann wie bei der Herstellung der ersten Öffnung gesteuert werden.

Nach Entfernen der erwähnten Fotolackschicht wird als Kondensator-Dielektrikum eine zweite isolierende Schicht 14 mindestens auf der ersten Elektrode 12 erzeugt, beispielsweise eine sogenannte ONO-Schicht. Durch die dabei auftretenden hohen Temperaturen findet eine Ausdiffusion von Dotierstoffen aus der ersten Elektrode 12 durch die erste Öffnung hindurch, d.h. über den Grabenkontakt 11, in das Halbleitersubstrat 1 statt, so daß dort ein leitendes Gebiet 15 des Auswahltransistors erzeugt wird. Anschließend wird in den Graben eine zweite Elektrodenschicht 16′ zur Bildung einer zweiten Elektrode 16 gebracht; üblicherweise wird dabei der gesamte Graben 7 mit Hilfe einer dicken dotierten Polysilizium-Schicht aufgefüllt, die dann wieder etwas zurückgeätzt wird. Dabei werden auch die Bereiche zwischen den primären Wortleitungen über den Isolationsgebieten 2 aufgefüllt.

Figur 6: Die nun vorliegende weitgehend eingeebnete Oberfläche wird mit einer weiteren (vierten) isolierender Schicht 18 abgedeckt, dazu wird eine etwa 200 nm dicke TEOS-Schicht abgeschieden. Die TEOS-Schicht 18 wird so strukturiert, daß sie als Maske für die Erzeugung eines Bitleitungs-Kontakts geeignet ist: Die Grabenwand mit dem Grabenkontakt 11 wird durch die TEOS-Schicht 18 abgedeckt, während auf der Seite des Grabens, welche die zweite Öffnung in der ersten Elektrodenschicht 12′ aufweist, die zweite Elektrodenschicht 16′ mindestens teilweise freiliegt. Aus der zweiten Elektrodenschicht 16′ wird nun eine zweite Elektrode 16 hergestellt, indem ein Bitleitungs-Kontaktloch 19 anisotrop geätzt wird bis in eine Tiefe, die unterhalb der Substratoberfläche 3 und vorzugsweise oberhalb der Oberkante der ersten Elektrode 12 an dieser Stelle liegt, wie der Figur 6 zu entnehmen ist. Die zweite Elektrodenschicht 16′ weist also wie die erste Elektrodenschicht eine zweite Öffnung auf, die im wesentlichen an der gleichen Stelle der Grabenwand 7˝ liegt und sich bis in eine geringere Tiefe im Graben erstreckt.An dieser Stelle der Grabenwand 7˝ liegt nun Siliziumnitrid 9 frei.

Auf der freiliegenden Oberfläche der zweiten Elektrode 16 wird eine dritte isolierende Schicht 17 erzeugt, vorzugsweise durch einen Oxidationsprozeß. Die Dicke der so gebildeten Siliziumoxid-Schicht 17 beträgt etwa 80 nm. Das freiliegende Nitrid 9 schützt diese Stelle der Grabenwand, den späteren Bitleitungs-Kontakt, vor der Oxidation.

Figur 7: In der Figur ist außer der in Rede stehenden Speicherzelle 24 noch der Auswahltransistor 25 der rechts benachbarten Speicherzelle dargestellt. Das an der Grabenwand 7˝ im Bereich der zweiten Öffnung freiliegende Siliziumnitrid 9 und das unterliegende Siliziumoxid 8 werden beispielsweise durch Naßätzprozesse entfernt, so daß in der ersten isolierenden Schicht 8,9 eine zweite Öffnung erzeugt wird, die an der gleichen Stelle wie die zweite Öffnung in der zweiten Elektrodenschicht 16′ liegt. An dieser Stelle liegt nun die ursprüngliche Grabenwand 7˝ frei. Die erste isolierende Schicht 8,9 besitzt also die erste und die zweite Öffnung, während die zweite isolierende Schicht 14 und beide Elektrodenschichten jeweils nur die zweite Öffnung aufweisen.Die zweite Öffnung in der ersten Elektrodenschicht 12′ reicht i.a. bis in eine größere Tiefe im Graben (d. h. die Oberkante der ersten Elektrode 12 liegt tiefer) als die übrigen zweiten Öffnungen, damit bei dem zuletzt erwähnten Naßätzprozeß das Kondensatordielektikum 14 nicht angegriffen werden kann. Bei einer hohen Selektivität des Ätzprozesses, mit dem die zweite Öffnung in der ersten isolierenden Schicht 8,9 hergestellt wird, zum Material des Dielektikums 14, kann diese Bedingung entfallen. Anschließend wird die Bitleitung 20,21 erzeugt, wobei im Bereich der zweiten Öffnung ein Bitleitungskontakt 22 gebildet wird. Üblicherweise wird zunächst ganzflächig eine etwa 500 nm dicke Polysilizium-Schicht 20 abgeschieden und auf etwa 100 nm rückgeätzt, wodurch bereits eine weitgehende Auffüllung des Bitleitungslochs 19 erreicht wird. Darüber wird als geeignetes Bitleitungs-Material beispielsweise Molybdän-Silizium 21 aufgebracht und zusammen mit der Polysilizium-Schicht 20 zur Bitleitung strukturiert. Die Bitleitung 20, 21 verläuft dann über dem Graben bzw. im Bereich des Bitleitungskontaktlochs 19 teilweise im Graben 7. Durch Ausdiffusion aus der Bitleitung 20,21 über den Bitleitungskontakt 22, beispielsweise bei einer nachfolgenden Temperung zur Silizierung des Molybdäns, wird ein zweites leitendes Gebiet 23 gebildet. Im Bereich der zweiten Öffnung besteht nun der Bitleitungskontakt 22 zwischen der Bitleitung 20,21 und dem zweiten leitenden Gebiet 23 (beispielsweise Drain) des Auswahltransistors der (in der Figur rechts) benachbarten Speicherzelle. Der Bitleitungskontakt einer Speicherzelle ist also immer im Graben bzw. an der Grabenwand einer in Bitleitungsrichtung (hier links) benachbarten Speicherzelle angeordnet.

Die dritte und die vierte isolierende Schicht 17,18 stellen die Isolation der zweiten Elektrode 16 gegenüber der Bitleitung 20,21 dar. Stattdessen ist es auch möglich, das Bitleitungsloch 19 und die zweite Öffnung in der zweiten Elektrodenschicht 16′ direkt mit Hilfe einer Fototechnik, ohne Verwendung einer vierten isolierenden Schicht 18, zu erzeugen und nach Entfernen des Fotolacks die gesamte Oberfläche zu oxidieren oder auf andere Weise eine durchgehende dritte isolierende Schicht 17 zu erzeugen. Die zusätzliche Verwendung der vierten isolierenden Schicht 18 bestehend aus TEOS hat jedoch den Vorteil einer besseren Isolationswirkung, ferner können die Anforderungen an die Fototechnik geringer sein, da das Bitleitungs-Kontaktloch 19 durch evt. Bildung von TEOS-Spacern noch verkleinert werden kann. Schließlich kann dadurch ein größerer Abtrag der Schicht 18 bei der Strukturierung der Bitleitung in Kauf genommen werden.

Figur 8: Die Aufsicht auf die Speichermatrix zeigt schematisch die Lage der Speicherzellen in Reihen zwischen den streifenförmigen Isolationsgebieten 2. Senkrecht zu den Bitleitungen 20, 21 verlaufen die mit TEOS 5,6 eingekapselten primären Wortleitungen 4′. Das durch die Isolationsgebiete 2 und die TEOS-Abdeckung 5,6 gebildete Raster stellt die Maske für die selbstjustierte Erzeugung der Gräben 7 dar.

Der Graben 7 einer Speicherzelle besitzt auf einer Seite den Grabenkontakt 11 zum Source-Gebiet seines Auswahltransistors, auf der gegenüberliegenden Seite ist der Bitleitungs-Kontakt 22 zwischen dem Auswahltransistor der benachbarten Speicherzelle und der Bitleitung 20,21 angeordnet. Mit 7a,11a und 22a sind der zu der in der Mitte liegenden Speicherzelle gehörende Graben, Grabenkontakt und Bitleitungskontakt bezeichnet.

Ferner sind schematisch drei Lithographieebenen angegeben:
- Mit einer Fotolackschicht, die mindestens die mit 31 bezeichneten Gebiete nicht bedeckt, wird die erste isolierende Schicht 8,9 geätzt (vgl. Figur 3, Fotolackschicht 10), so daß an der ersten Stelle der Grabenwand die erste Öffnung zur Herstellung des Grabenkontakts 11 entsteht.
- Mit einer weiteren Fotolackschicht, die mindestens die mit 32 bezeichneten Gebiete nicht bedeckt, wird die erste Elektrodenschicht 12′ geätzt (Herstellung der zweiten Öffnung in der ersten Elektrodenschicht 12′), so daß in jedem Graben 7 eine von den übrigen getrennte erste Elektrode liegt (vgl. Figuren 4 und 5). In Richtung der Wortleitungen 4′ müssen die Gebiete 32 jeweils mindestens bis zu den Isolationsstreifen 2 reichen.
- Mit einer weiteren Fotolackschicht, die mindestens die mit 33 bezeichneten Gebiete nicht bedeckt, wird das Bitleitungs-Kontaktloch 19 hergestellt durch Ätzen der vierten isolierenden Schicht 18 (vgl. Figur 6), wodurch in nachfolgenden Schritten die zweite Öffnung in der zweiten Elektrodenschicht 16′ und in der ersten isolierenden Schicht 8,9 hergestellt und der Bitleitungs-Kontakt 22 an der zweiten Stelle der Grabenwand erzeugt wird.

Die Öffnungen 32 und 33 können wie in Figur 8 angegeben deckungsgleich sein, ihr Überlapp muß zumindest die Herstellung eines ausreichenden Bitleitungs-Kontaktes ermöglichen. Die Gebiete 31,32,33 können in anderer Form, insbesondere größer gewählt werden als in der Figur angegeben. Auch können sie sich teilweise überdecken. Meist müssen die Öffnungen in den Fotolackschichten größer gewählt werden, um Justierfehler, Auflösungsvermögen u. a. zu berücksichtigen. Es ist vorteilhaft, wenn die Gebiete 31 und/oder 32 und/oder 33 in der zweiten Richtung zu beiden Seiten die Isolationsgebiete 2 noch je zur Hälfte überdecken. Die Ausdehnung in der ersten Richtung wird meist durch das Auflösungsvermögen bestimmt; insbesondere Gebiet 32 kann aber aus Zuverlässigkeitsgründen auch so gewählt werden, daß es den Graben 7 etwa bis zur Hälfte überdeckt.

Aus der Figur 8 ist weiterhin die erfinderische Anordnung der Speicherzellen in einer Speichermatrix zu erkennen:
- Die Speicherzellen sind in Reihen angeordnet, die parallel zu den Bitleitungen 20,21 verlaufen (erste Richtung) und durch die streifenförmigen Isolationsgebiete 2 voneinander getrennt sind. Bei allen Speicherzellen in derselben Reihe ist der Auswahltransistor auf derselben Seite des zugehörigen Kondensators angeordnet, beispielsweise in der mit A-A bezeichneten Reihe liegen alle Auswahltransistoren links vom zugehörigen Kondensator. Eine solche Reihe ist auch in den Figuren 2 bis 7 im Querschnitt dargestellt. Dementsprechend befindet sich an der linken Grabenoberkante der Grabenkontakt 11, an der rechten Grabenoberkante der Bitleitungs-Kontakt 22 der benachbarten Speicherzelle. In einer benachbarten Reihe von Speicherzellen ist diese Orientierung umgekehrt: Alle Auswahltransistoren befinden sich rechts vom zugehörigen Kondensator, Grabenkontakt 11 und Bitleitungskontakt 22 sind entsprechend vertauscht. In Richtung der Wortleitungen 4′ (zweite Richtung) befinden sich alle Auswahltransistoren in einer Reihe, ebenso alle Gräben 7.

Diese Speichermatrix ist besonders vorteilhaft zur Erzielung einer möglichst kompakten Zelle. Sie stellt nur geringe Anforderungen an die verwendete Fototechnik, die Separierung der ersten Elektroden in verschiedenen Gräben voneinander ist einfach möglich. An jeder Kreuzung von Wortleitung und Bitleitung entsteht eine Speicherzelle. Typische Werte für die Größe einer solchen Speicherzelle sind:
Wortleitungs-Raster: 2,1 »m, Wortleitungs-Breite: 0,7 »m Bitleitungs-Raster: 1,4 »m, Bitleitungs-Breite: 0,7 »m Kondensatorgraben: 1,4 »m x 0,7 »m, Grabentiefe: 3 »m, Zellfläche: 2,94 »m², c = 6.

Ein Vorteil des erfinderischen Verfahrens ist seine einfache Integrationsmöglichkeit mit anderen üblichen Verfahren bei der Herstellung von höchstintegrierten Schaltungen. Beispielsweise kann bei Transistoren in der Peripherie der Bitleitungs-Kontakt nach dem "FOBIC"-Konzept hergestellt werden, wenn nach der Implantation der Peripherie-Transistoren in der Peripherie eine dünne Nitridschicht und darauf ein verfließendes Zwischenoxid erzeugt werden (s. Küsters et al., Proc. of the 1987 Symposium on VLSI Technology, Nagano, Japan, S. 93 - 94). Nach der Erzeugung der dritten isolierenden Schicht wird dann in der Peripherie über dem zu kontaktierenden Transistor ein Loch in das Zwischenoxid bis zur unterliegenden dünnen Nitridschicht geätzt. Gleichzeitig mit der Herstellung des Bitleitungskontakts im Speicherfeld (Entfernen der ersten isolierenden Schicht 8, 9 am Bitleitungskontakt 22) kann der Bitleitungs-Kontakt in der Peripherie durch Entfernen der dünnen Nitridschicht geöffnet werden.

Figur 9:
Zur Erhöhung der Bewertungssicherheit beim open-bitline Konzept sind außer den bereits erläuterten primären Wortleitungen 4′ aus Polysilizium sekundäre Wortleitungen 40 und tertiäre Wortleitungen 41 vorgesehen, die in überliegenden Metallisierungsebenen angeordnet sind. Aus Gründen der Übersichtlichkeit ist die sekundäre Wortleitung 40 schmaler dargestellt als die tertiäre Wortleitung 41.

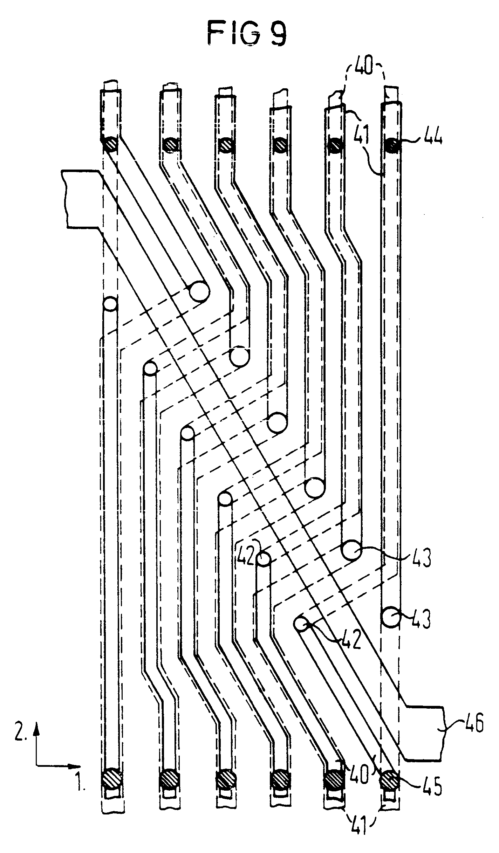

Durch eine im folgenden erläuterte spezielle Anordnung und ein spezielles Verdrahtungskonzept von primärer, sekundärer und tertiärer Wortleitung 4′, 40, 41 wird eine dem Folded-Bitleitungs-Schema ähnliche Beschaltung der Speicherzellen erreicht: Die sekundäre Wortleitung 40 und die tertiäre Wortleitung 41 verlaufen abwechselnd in einer ersten und einer darüberliegenden zweiten Metallisierungsebene, wobei sie verdrillt sind:
Beispielsweise verläuft die sekundäre Wortleitung 40 über eine Länge X in der ersten Metallisierungsebene (in der Figur gestrichelt dargestellt), wird dann über ein sogenanntes Via 42 in die zweite Metallisierungsebene hochgeführt, verläuft über eine im allgemeinen gleichlange Strecke in der zweiten Metallisierungsebene (durchgezogene Linie) und wird dann über ein weiteres Via wieder in die erste Metallisierungsebene geführt. Die tertiäre Wortleitung 41 verläuft komplementär zur sekundären Wortleitung, d. h. im wesentlichen parallel zu ihr und bis auf die Umgebung der Vias in der jeweils anderen Metallisierungsebene; über ein Via 43 wird sie von der zweiten in die erste Metallisierungsebene geführt. An den Vias 42, 43 muß für einen kreuzungsfreien Wechsel der Wortleitungen in die jeweils andere Ebene gesorgt werden, was bei der in der Figur 9 angegebenen Anordnung von Vias und Wortleitungen erreicht wird und zur Verdrillung von sekundärer und tertiärer Wortleitung 40, 41 führt. In der ersten Metallisierungsebene liegt also abwechselnd jeweils über die Länge X die sekundäre 40 und die tertiäre Wortleitung 41 vor.

Die primäre Wortleitung 4′ (nicht dargestellt) wird in der Polysiliziumschicht nicht durchgehend, sondern in Abschnitten angelegt, die jeweils beispielsweise über 16 Zellen laufen. Vorzugsweise in der Mitte eines solchen Abschnitts befindet sich ein Kontakt 44, 45 zur überliegenden ersten Metallisierungsebene, d. h. also entweder zur sekundären 40 oder tertiären Wortleitung 41. Die primäre Wortleitung (bzw. ihre Abschnitte) verläuft zwischen zwei solchen Kontakten 44, 45 vorzugsweise geradlinig. Zwischen den Kontakten 44, 45 zweier in Wortleitungs-Richtung benachbarter primärer Wortleitungs-Abschnitte ist (in den darüber liegenden Metallisierungsebenen) der kreuzungsfreie Wechsel der sekundären und tertiären Wortleitung in die jeweils andere Metallisierungsebene angeordnet, so daß von zwei in Wortleitungs-Richtung benachbarten primären Wortleitungs-Abschnitten der eine mit der sekundären Wortleitung 40 über den Kontakt 44, der andere mit der tertiären Wortleitung 41 über den Kontakt 45 verbunden ist. Die Länge X hängt also mit der Länge der primären Wortleitungs-Abschnitte zusammen, im einfachsten Fall sind diese beiden Größen etwa gleich. Aus Gründen der Übersichtlichkeit sind die Vias und Kontakte entsprechend den Wortleitungen in verschiedener Größe dargestellt.

Wird nun die sekundäre Wortleitung 40 oder die tertiäre Wortleitung 41 angesprochen, so wird nur ein solcher Abschnitt der primären Wortleitung angesprochen, über dem diese Wortleitung in der ersten Metallisierungsebene läuft; damit werden nun die 16 Zellen ausgelesen, die in diesem Abschnitt liegen. Die benachbarten 16 Zellen werden nicht angesprochen. Es wird zum Bewerten des Signals eine Bitleitung des angesprochenen Abschnitts mit einer des benachbarten Abschnitts verglichen. Als Referenz-Bitleitung beim Auslesen einer Zelle dient also nicht die jeweils nächste oder übernächste Bitleitung wie sonst üblich, sondern in diesem Ausführungsbeispiel die jeweils sechzehnte. An den Leseverstärkern ist eine Zusammenführung dieser Bitleitungen beispielsweise über Metallbrücken erforderlich.

Der Kontakt 44, 45 zwischen primärer Wortleitung und sekundärer Wortleitung sowie das Via 42, 43 beim Wechsel einer sekundären oder tertiären Wortleitung in die andere Metallisierungsebene soll möglichst wenig Platz beanspruchen. Vorteilhaft sind daher solche Ausführungsformen, bei denen die elektrisch zu verbindenden Leitungen an der Verbindungsstelle nicht verbreitert werden; solche Verbindungen werden als non-nested/non-capped bezeichnet, wenn keine der beiden Leitungen verbreitert wird. Realisieren lassen sich solche Verbindungen beispielsweise durch mit Wolfram aufgefüllte Kontaktlöcher zwischen primärer und sekundärer Wortleitung und durch mit Wolfram aufgefüllte Vias zwischen sekundärer und tertiärer Wortleitung. Ein Kontakt 44 zwischen primärer und sekundärer Wortleitung ist vorzugsweise über einem Isolationsgebiet 2 (vgl. Figur 8) und nicht über dem Auswahltransistor angeordnet; hierzu kann es erforderlich sein, daß der unter einem Kontakt 44 liegende Streifen des Isolationsgebietes 2 eine größere Breite, beispielsweise 1,6 »m bei oben genannten Rastern bzw. Strukturgrößen, aufweist, als die Streifen des Isolationsgebietes 2, über denen kein Kontakt 44 angeordnet ist. Ebenso kann es erforderlich sein, an der Trennstelle zweier Abschnitte der primären Wortleitung den unterliegenden Streifen des Isolationsgebietes 2 zu verbreitern, etwa auf 1,2 »m.

Der für ein Via 42, 43, d. h. für den Wechsel der sekundären oder tertiären Wortleitung in die jeweils andere Metallisierungsebene erforderliche Platz bestimmt, wie kurz die Abschnitte der primären Wortleitung sein dürfen, und damit, wie weit die zu vergleichenden Bitleitungen auseinanderliegen. Um die Anzahl der notwendigen Bitdekoder zu reduzieren, ist es vorteilhaft, eine zusätzliche Auswahlleitung 46 (sog. column-select-Leitung), die mit einem zentralen Vordekodierer und mit einem Leseverstärker verbunden ist, in der Halbleiterspeicheranordnung vorzusehen. Die Auswahlleitung 46 kann in der zweiten Metallisierungsebene angeordnet werden, wenn die in Figur 9 dargestellte spezielle Anordnung der sekundären und tertiären Wortleitungen 40, 41, der Kontakte 44, 45 und der Vias 42, 43 bei einer Länge der primären Wortleitungs-Abschnitte von 16 Zellen gewählt wird. Dazu ist es im allgemeinen, beispielsweise bei den angegebenen Dimensionierungen, nicht erforderlich, den Abstand der Kontakte 44 in Bitleitungsrichtung (erste Richtung) zu vergrößern, dieser Abstand ist durch die angegebenen Ausmaße des Grabens 7 festgelegt. Der Einsatz der in Bitleitungsrichtunng verlaufenden Leitungen kann je nach Schaltungskonzept auch zu einem anderen Zweck erfolgen, nicht nur als Auswahlleitungen im obigen Sinne.

## Patentansprüche

1. Halbleiterspeicheranordnung mit Wortleitungen, Bitleitungen und Speicherzellen in einem Halbleitersubstrat (1) , wobei
- jede Speicherzelle (24) einen überwiegend in einem Graben (7) angeordneten Kondensator und einen MOS-Auswahltransistor aufweist,
- ein vertikaler Grabenkontakt (11) zwischen einem ersten leitenden Gebiet (15) des Auswahltransistors und einer ersten Elektrode (12) des Kondensators an einer ersten Stelle der Grabenwand (7˝) angeordnet ist,
**dadurch gekennzeichnet,** daß
- die Bitleitung (20, 21) zumindest teilweise im Graben (7) verläuft, und
- an einer zweiten Stelle der Grabenwand (7˝) ein vertikaler Bitleitungskontakt (22) zwischen der Bitleitung und einem zweiten leitenden Gebiet (22) des Auswahltransistors der benachbarten Speicherzelle (25) angeordnet ist.

2. Halbleiterspeicheranordnung nach Anbspruch 1,
**gekennzeichnet durch**
folgende Merkmale:
- Eine aus einer ersten Elektrodenschicht (12′) gebildete erste Elektrode (12) und eine aus einer zweiten Elektrodenschicht (16′) gebildete zweite Elektrode (16) des Kondensators sind überwiegend im Graben (7) angeordnet,
- eine erste isolierende Schicht (8,9), welche die aus Wand (7˝) und Boden (7′) bestehende Grabenoberfläche im wesentlichen bedeckt, isoliert die erste Elektrode (12) vom Halbleitersubstrat (1),
- eine zweite isolierende Schicht (14), welche mindestens die erste Elektrode (12) bedeckt, isoliert die zweite Elektrode (16) von der ersten Elektrode (12),
- durch eine erste Öffnung in der ersten isolierenden Schicht (8,9) an der ersten Stelle der Grabenwand (7˝) ist das erste leitende Gebiet (15) des Auswahltransistors mit der ersten Elektrode (12) unter Bildung des Grabenkontaktes (11) verbunden,
- mindestens eine dritte isolierende Schicht (17) isoliert die zweite Elektrode (16) von der überliegenden und teilweise im Graben (7) verlaufenden Bitleitung (20,21),
- an der zweiten Stelle der Grabenwand (7˝) befinden sich jeweils eine zweite Öffnung in der ersten und zweiten Elektrodenschicht (12′), (16′) und in der ersten und zweiten isolierenden Schicht (8,9), (14) derart, daß die an dieser Stelle im Graben (7) verlaufende Bitleitung (20, 21) durch die zweiten Öffnungen hindurch den Bitleitungs-Kontakt (22) mit dem zweiten leitenden Gebiet (23) des Auswahltransistors (25) der benachbarten Speicherzelle besitzt.

3. Halbleiterspeicheranordnung nach einem der Ansprüche 1 bis 2, **dadurch gekennzeichnet,** daß der Graben (7) der Speicherzelle (24) selbstjustiert zu einem Gate (4) des Auswahltransistors, zum Gate (4˝) des Auswahltransistors (25) der benachbarten Speicherzelle und zu einem verschiedene Speicherzellen isolierenden Isolationsgebiet (2) angeordnet ist.

4. Halbleiterspeicheranordnung nach einem der Ansprüche 1 bis 3, **dadurch gekennzeichnet**, daß die erste Elektrode (12) mindestens die erste Öffnung und größtenteils die erste isolierende Schicht (8,9) an der Grabenwand (7˝) und am Grabenboden (7′) bedeckt.

5. Halbleiterspeicheranordnung nach einem der Ansprüche 1 bis 4, **dadurch gekennzeichnet,** daß die erste Elektrodenschicht (12′) eine sich mit den übrigen zweiten Öffnungen im wesentlichen überdeckende, aber sich in größerer Tiefe im Graben erstreckende zweite Öffnung aufweist.

6. Halbleiterspeicheranordnung nach einem der Ansprüche 1 bis 5, **dadurch gekennzeichnet**, daß die erste isolierende Schicht (8,9) eine Doppelschicht bestehend aus Siliziumoxid (8) und darüberliegendem Siliziumnitrid (9) ist.

7. Halbleiterspeicheranordnung nach einem der Ansprüche 1 bis 6, **dadurch gekennzeichnet**, daß der Bitleitungs-Kontakt (22) an einer dem Grabenkontakt (11) gegenüberliegenden Stelle der Grabenwand (7˝) angeordnet ist.

8. Halbleiterspeicheranordnung nach einem der Ansprüche 1 bis 7, **gekennzeichnet durch** eine vierte isolierende Schicht (18), die den außerhalb des Grabens (7) verlaufenden Teil der Bitleitung (20,21) von der zweiten Elektrode (16) isoliert.

9. Halbleiterspeicheranordnung nach einem der Ansprüche 1 bis 8, **gekennzeichnet durch** eine durch pyrolytische Zersetzung von Tetraethylorthosilikat (TEOS) hergestellte vierte isolierende Schicht (18) und eine aus Polysiliziumoxid bestehende dritte isolierende Schicht (17).

10. Verfahren zur Herstellung einer Halbleiterspeicheranordnung nach einem der Ansprüche 1 bis 9 mit folgenden Schritten:
a) Herstellen von im wesentlichen streifenförmigen Isolationsgebieten (2) zur Isolierung verschiedener Speicherzellen voneinander,
b) Herstellen einer primären Wortleitung (4′) mit dem Gate (4) des Auswahltransistors,
c) Herstellen eines Grabens (7) zur Aufnahme des Kondensators selbstjustiert zum Isolationsgebiet (2), zum Gate (4) und zum Gate (4˝) eines benachbarten Auswahltransistors (25),
d) Herstellen einer ersten isolierenden Schicht (8,9) auf der Grabenwand (7˝) und dem Grabenboden (7′) mit einer ersten Öffnung in der ersten isolierenden Schicht an der ersten Stelle der Grabenwand,
e) Herstellen einer ersten Elektrode (12) durch Aufbringen einer ersten Elektrodenschicht (12′) auf der ersten isolierenden Schicht (8,9) und auf dem durch die erste Öffnung freigelegten Teil der Grabenwand (7˝) und Erzeugen einer zweiten Öffnung in der ersten Elektrodenschicht (12′) an der zweiten Stelle der Grabenwand,
f) Herstellen einer zweiten isolierenden Schicht (14) mindestens auf der ersten Elektrode (12),
g) Auffüllen des Grabens (7) mit einer zweiten Elektrodenschicht (16′),
h) Herstellen einer zweiten Elektrode (16) aus der zweiten Elektrodenschicht (16′) durch Erzeugen einer zweiten Öffnung in der zweiten Elektrodenschicht (16′), welche mindestens teilweise die zweite Öffnung in der ersten Elektrodenschicht überdeckt,
i) Herstellen mindestens einer dritten isolierenden Schicht (17) auf der freiliegenden Oberfläche der zweiten Elektrode (16),
k) Entfernen der an der zweiten Stelle der Grabenwand (7˝) vorhandenen Schichten (8,9,14),
l) Herstellen einer Bitleitung (20, 21), welche teilweise über und teilweise in dem Graben (7) verläuft und an der zweiten Stelle der Grabenwand einen Bitleitungs-Kontakt (22) zum zweiten leitenden Gebiet (23) des Auswahltransistors (25) der benachbarten Speicherzelle besitzt.

11. Verfahren nach Anspruch 10,
**dadurch gekennzeichnet,** daß die erste Elektrodenschicht (12′) durch ganzflächige Abscheidung von Polysilizium und eine anisotrope Rückätzung hergestellt wird, wobei der Graben (7) bis über die am Grabenkontakt (11) gebildete Stufe in der ersten leitenden Schicht mit Lack (13) aufgefüllt ist.

12. Verfahren nach einem der Ansprüche 9 bis 11,
**dadurch gekennzeichnet**, daß nach Auffüllen des Grabens (7) mit der zweiten Elektrodenschicht (16′) diese mit einer vierten isolierenden Schicht (18) abgedeckt wird.

13. Verfahren nach Anspruch 12,
**dadurch gekennzeichnet**, daß die vierte isolierende Schicht (18) mit einer Fototechnik so strukturiert wird, daß anschließend mit ihr als Maske die zweite Öffnung in die zweite Elektrodenschicht (16′) geätzt wird.

14. Speichermatrix mit mindestens vier Speicherzellen einer Halbleiterspeicheranordnung nach einem der Ansprüche 1 bis 9, wobei die Speicherzellen folgendermaßen angeordnet sind:
- In einer ersten Richtung, die parallel zur geometrischen Verbindungslinie zwischen Auswahltransistor und Kondensator verläuft, sind die Speicherzellen in Reihen angeordnet, die voneinander durch die Isolationsgebiete (2) getrennt sind,
- die in derselben Reihe liegenden Speicherzellen besitzen den Auswahltransistor auf einer festgelegten Seite des Kondensators,
- in der benachbarten Reihe ist der zugehörige Auswahltransistor auf der entgegengesetzten Seite des Kondensators angeordnet,
- in einer zweiten, zur ersten senkrecht verlaufenden Richtung sind die Auswahltransistoren in einer Reihe angeordnet,
- in der zweiten Richtung sind die Gräben (7) in einer Reihe angeordnet.

15. Halbleiterspeicheranordnung nach einem der Anspruche 1 - 9, welche entsprechend einem open-bitline-Konzept beschaltet sind, mit folgenden Merkmalen:
- in zwei uberliegenden Metallisierungsebenen sind sekundäre 40) und tertiare Wortleitungen (41) angeordnet, die jeweils abwechselnd in der ersten und in der zweiten Metallisierungsebene verlaufen,
- jeweils eine sekundare (40) und eine tertiare Wortleitung (41) sind in der ersten und zweiten Metallisierungsebene im wesentlichen übereinander und über einer primaren Wortleitung (4′) angeordnet und werden beim Wechsel in die jeweils andere Metallisierungsebene kreuzungsfrei aneinander vorbeigefuhrt,
- die primare Wortleitung (4′) ist in Abschnitte unterteilt, wobei jeder Abschnitt über einen Kontakt (44, 45) mit der darüber in der ersten Metallisierungsebene verlaufenden Wortleitung ( 40,41) verbunden ist.

16. Hableiterspeicheranordnung nach Anspruch 15,
**dadurch gekennzeichnet**, daß in einer Umgebung des kreuzungsfreien Wechsels die sekundare und die tertiare Wortleitung (40, (41) beide größtenteils in einer der beiden Metallisierungsebenen verlaufen und in der anderen Metallisierungsebene eine Auswahlleitung (46) angeordnet ist.

## Claims

1. Semiconductor storage arrangement having word lines, bit lines and storage cells in a semiconductor substrate (1),
- each storage cell (24) having a capacitor, which is arranged predominantly in a trench (7), and an MOS selection transistor,
- a vertical trench contact (11) being arranged between a first conductive region (15) of the selection transistor and a first electrode (12) of the capacitor, at a first point on the trench wall (7˝),
characterized in that
- the bit line (20, 21) runs at least partially in the trench (7), and
- a vertical bit line contact (22) is arranged at a second point on the trench wall (7˝), between the bit line and a second conductive region (22) of the selection transistor of the adjacent storage cell (25).

2. Semiconductor storage arrangement according to Claim 1, characterized by the following features:
- a first electrode (12), formed from a first electrode layer (12′), and a second electrode (16), formed from a second electrode layer (16′), of the capacitor are predominantly arranged in the trench (7),
- a first insulating layer (8,9), which essentially covers the trench surface consisting of the wall (7˝) and the base (7′), insulates the first electrode (12) from the semiconductor substrate (1),
- a second insulating layer (14), which covers at least the first electrode (12), insulates the second electrode (16) from the first electrode (12),
- the first conductive region (15) of the selection transistor is connected to the first electrode (12), forming the trench contact (11), through a first opening in the first insulating layer (8,9) at the first point on the trench wall (7˝),
- at least a third insulating layer (17) insulates the second electrode (16) from the bit line (20,21) which is located above it and runs partially in the trench (7),
- a second opening in the first and second electrode layers (12′), (16′) respectively and in the first and second insulating layer (8,9), (14) respectively are located at the second point on the trench wall (7˝) in such a manner that the bit line (20,21) which runs at this point in the trench (7) through the second openings has the bit line contact (22) with the second conductive region (23) of the selection transistor (25) on the adjacent storage cell.

3. Semiconductor storage arrangement according to either of Claims 1 and 2, characterized in that the trench (7) of the storage cell (24) is arranged in a self-adjusted manner with respect to a gate (4) of the selection transistor, with respect to the gate (4˝) of the selection transistor (25) of the adjacent storage cell and with respect to an insulation region (2) which insulates different storage cells.

4. Semiconductor storage arrangement according to one of Claims 1 to 3, characterized in that the first electrode (12) covers at least the first opening and the majority of the first insulating layer (8,9) on the trench wall (7˝) and on the trench base (7′).

5. Semiconductor storage arrangement according to one of Claims 1 to 4, characterized in that the first electrode layer (12′) has a second opening which is essentially superimposed on the other second openings but extends at a greater depth in the trench.

6. Semiconductor storage arrangement according to one of Claims 1 to 5, characterized in that the first insulating layer (8,9) is a double layer consisting of silicon oxide (8) and silicon nitride (9) located above it.

7. Semiconductor storage arrangement according to one of Claims 1 to 6, characterized in that the bit line contact (22) is arranged at a point on the trench wall (7˝) located opposite the trench contact (11).

8. Semiconductor storage arrangement according to one of Claims 1 to 7, characterized by a fourth insulating layer (18), which insulates the part of the bit line (20,21) running outside the trench (7) from the second electrode (16).

9. Semiconductor storage arrangement according to one of Claims 1 to 8, characterized by a fourth insulating layer (18), which is produced by pyrolytic decomposition of tetra-ethyl orthosilicate (TEOS), and by a third insulating layer (17), which consists of polysilicon oxide.

10. Method for producing a semiconductor storage arrangement according to one of Claims 1 to 9, having the following steps:
a) Production of essentially strip-shaped insulation regions (2) for insulating various storage cells from one another,
b) Production of a primary word line (4′) with the gate (4) of the selection transistor,
c) Production of a trench (7) for holding the capacitor in a self-adjusted manner with respect to the insulation region (2), to the gate (4) and to the gate (4˝) of an adjacent selection transistor (25),
d) Production of a first insulating layer (8,9) on the trench wall (7˝) and the trench base (7′), having a first opening in the first insulating layer at the first point on the trench wall,
e) Production of a first electrode (12) by the application of a first electrode layer (12′) on the first insulating layer (8,9) and on the part of the trench wall (7˝) exposed by the first opening, and production of a second opening in the first electrode layer (12′) at the second point on the trench wall,
f) Production of a second insulating layer (14) at least on the first electrode (12),
g) Filling of the trench (7) with a second electrode layer (16′),
h) Production of a second electrode (16) out of the second electrode layer (16′) by production of a second opening in the second electrode layer (16′), which at least partially covers the second opening in the first electrode layer,
i) Production of at least one third insulating layer (17) on the exposed surface of the second electrode (16),
k) Removal of the layers (8,9,14) which exist at the second point on the trench wall (7˝),
l) Production of a bit line (20,21), which runs partially above and partially in the trench (7) and, at the second point on the trench wall, has a bit line contact (22) for the second conductive region (23) of the selection transistor (25) of the adjacent storage cell.

11. Method according to Claim 10, characterized in that the first electrode layer (12′) is produced by depositing polysilicon over the entire area and an anisotropic etching back, the trench (7) being filled with photoresist (13) to above the step which is formed on the trench contact (11) in the first conductive layer.

12. Method according to one of Claims 9 to 11, characterized in that, after the trench (7) is filled with the second electrode layer (16′), said layer is covered with a fourth insulating layer (18).

13. Method according to Claim 12, characterized in that the fourth insulating layer (18) is structured using a photographic technique such that the second opening is subsequently etched into the second electrode layer (16′) using it as a mask.

14. Storage matrix having at least four storage cells of a semiconductor storage arrangement according to one of Claims 1 to 9, the storage cells being arranged as follows:
- the storage cells are arranged in rows in a first direction which runs parallel to the geometrical connection line between the selection transistor and the capacitor, the rows being separated from one another by the insulation regions (2),
- the storage cells which are located in the same row have the selection transistor on a defined side of the capacitor,
- the associated selection transistor in the adjacent row is arranged on the opposite side of the capacitor,
- the selection transistors are arranged in a row in a second direction running at right angles to the first,
- the trenches (7) are arranged in a row in the second direction.

15. Semiconductor storage arrangement according to one of Claims 1-9, which is connected according to an open bit-line concept, having the following features:
- secondary (40) and tertiary (41) word lines are arranged in two superimposed metallization planes, which word lines respectively run alternatively in the first and in the second metallization plane,
- in each case one secondary (40) and one tertiary (41) word line are arranged essentially one above the other in the first and second metallization plane, and above a primary word line (4′), and are passed by one another without crossing when they alternate into the respectively other metallization plane,
- the primary word line (4′) is divided into sections, each section being connected via a contact (44, 45) to the word line (40, 41) running above it in the first metallization plane.

16. Semiconductor storage arrangement according to Claim 15, characterized in that, in a region around the crossing-free alternation, the secondary and the tertiary word lines (40), (41) both run to a very large extent in one of the two metallization planes, and a selection line (46) is arranged in the other metallization plane.

## Revendications

1. Dispositif de mémoire à semiconducteur comportant des lignes de transmission de mots, des lignes de transmission de bits et des cellules de mémoire dans un substrat semiconducteur (1), et dans lequel
- chaque cellule de mémoire (24) comporte un condensateur disposé essentiellement dans un sillon (7), et un transistor de sélection MOS,
- un contact vertical de sillon (11) est disposé entre une première région conductrice (4) du transistor de sélection et une première électrode (12) du condensateur en un premier emplacement de la paroi (7˝) du sillon,
caractérisé par le fait
- que la ligne de transmission de bits (20,21) s'étend au moins en partie dans le sillon (7), et
- qu'un contact vertical (22) de la ligne de transmission de bits est disposé, en un second emplacement de la paroi (7˝) du sillon, entre la ligne de transmission de bits et une seconde région conductrice (22) du transistor de sélection de la cellule de mémoire voisine (25).

2. Dispositif de mémoire à semiconducteur suivant la revendication 1, caractérisé par les particularités suivantes :
- une première électrode (12), formée d'une première couche d'électrode (12′), et une seconde électrode (16) du condensateur, formée d'une seconde couche d'électrode (16′) sont disposées essentiellement dans le sillon (7),
- une première couche isolante (8,9), qui recouvre sensiblement la surface du sillon constituée de la paroi (7˝) et d'un fond (7′), isole du substrat semiconducteur (1) la première électrode (12),
- une seconde couche isolante (14), qui recouvre au moins la première électrode (12), isole de la première électrode (12) la seconde électrode (16),
- la première région conductrice (15) du transistor de sélection est reliée à la première électrode (12) par formation du contact (11) de sillon, au travers de la première ouverture dans la première couche isolante (8,9) au premier emplacement de la paroi (7˝) du sillon,
- au moins une troisième couche isolante (17) isole de la ligne de transmission de bits au-dessus (20,21), qui s'étend partiellement dans le sillon (7), la seconde électrode (16)
- une seconde ouverture se trouve, au second emplacement de la paroi (7˝) du sillon, dans les première et seconde couches d'électrodes (16′) et dans les première et seconde couches isolantes (8, 9), (14), de telle sorte que la ligne de transmission de bits (20,21), qui s'étend en c cet emplacement dans le sillon (7), ait, au travers des secondes ouvertures, le contact (22) reliant cette ligne de transmission de bits à la seconde région conductrice (23) du transistor de sélection (25) de la cellule de mémoire voisine.

3. Dispositif de mémoire à semiconducteur suivant l'une des revendications 1 et 2, caractérisé par le fait que le sillon (7) de la cellule de mémoire (24) est disposé d'une manière auto-ajustée avec une grille (4) du transistor de sélection, avec la grille (4˝) du transistor de sélection (25) de la cellule de mémoire voisine et avec une région isolante (2), qui isole des cellules de mémoire différentes.

4. Dispositif de mémoire à semiconducteur suivant l'une des revendications 1 à 3, caractérisé par le fait que la première électrode (12) recouvre au moins la première ouverture et en majeure partie la première couche isolante (8,9) sur la paroi (7˝) du sillon et au fond (7′) du sillon.

5. Dispositif de mémoire à semiconducteurs suivant l'une des revendications 1 à 4, caractérisé par le fait que la première couche d'électrode (12′) a une seconde ouverture, qui recouvre sensiblement les autres secondes ouvertures, mais qui s'étend à une plus grande profondeur dans le sillon.

6. Dispositif de mémoire à semiconducteur suivant l'une des revendications 1 à 5, caractérisé par le fait que la première couche isolante (8,9) est une couche double constituée d'oxyde de silicium (8) et du nitrure de silicium au-dessus (9).

7. Dispositif de mémoire à semiconducteur suivant l'une des revendications 1 à 6, caractérisé par le fait que le contact (22) de la ligne de transmission de bits est disposé en un emplacement de la paroi (7˝) du sillon, qui est en face du contact (11) de sillon.

8. Dispositif de mémoire à semiconducteur suivant l'une des revendications 1 à 7, caractérisé par une quatrième couche isolante (18), qui isole la partie, qui s'étend à l'extérieur du sillon (7), de la ligne de transmission de bits (20,21) vis-à-vis de la seconde électrode (16).

9. Dispositif de mémoire à semiconducteur suivant l'une des revendications 1 à 8, caractérisé par une quatrième couche isolante (18) formée par décomposition pyrolytique d'orthosilicate de tétraéthyle (TEOS), et une troisième couche isolante (17) formée d'oxyde de polysilicium.

10. Procédé pour fabriquer un dispositif de mémoire à semiconducteur suivant l'une des revendications 1 à 9 comportant les étapes suivantes :
a) fabrication de régions isolantes (2) sensiblement en forme de bande pour l'isolation l'une de l'autre de cellules de mémoire différentes,
b) fabrication d'une ligne primaire de transmission de mots (4′) ainsi que de la grille (4) du transistor de sélection,
c) fabrication d'un sillon (7) destiné à recevoir le condensateur d'une manière auto-ajustée par rapport à la région isolante (2), à la grille (4) et à la grille (4˝) d'un transistor de sélection voisin (25),
d) fabrication d'une première couche isolante (8,9) sur la paroi (7˝) du sillon et sur le fond (7′) du sillon ayant une première ouverture dans la première couche isolante au premier emplacement de la paroi du sillon,
e) fabrication d'une première électrode (12) par dépôt d'une première couche d'électrode (12′) sur la première couche isolante (8,9) et sur la partie, qui est mise à nu par la première ouverture, de la paroi (7˝) du sillon, et production d'une seconde ouverture dans la première couche d'électrode (12′) au second emplacement de la paroi du sillon,
f) fabrication d'une seconde couche isolante (14) au moins sur la première électrode (12),
g) remplissage du sillon (7), d'une seconde couche d'électrode (16′),
h) fabrication d'une seconde électrode (16) à partir de la seconde couche d'électrode (16′) par production d'une seconde ouverture dans la seconde couche d'électrode (16′), qui recouvre au moins partiellement la seconde ouverture dans la première couche d'électrode,
i) fabrication d'au moins une troisième couche isolante (17) sur la surface à nu de la seconde électrode (16),
k) élimination des couches (8,9,14) présentes au second emplacement de la paroi (7˝) du sillon,
l) fabrication d'une ligne de transmission de bits (20,21), qui s'étend en partie au-dessus et en partie dans le sillon (7) et a, au second emplacement de la paroi du sillon, un contact (22) reliant cette ligne à la seconde région conductrice (23) du transistor de sélection (25) de la cellule de mémoire voisine.

11. Procédé suivant la revendication 10, caractérisé par le fait qu'on fabrique la première couche d'électrode (12′) en effectuant un dépôt de polysilicium sur toute la surface et par attaque chimique anisotrope en retrait, le sillon (7) étant rempli d'un vernis (13) jusqu'au-dessus de l'étage, formé au contact (11) du sillon, dans la première couche conductrice.

12. Procédé suivant l'une des revendications 9 à 11, caractérisé par le fait qu'après le remplissage du sillon (7) de la seconde couche d'électrode (16′), on recouvre cette dernière par une quatrième couche isolante (18).

13. Procédé suivant la revendication 12, caractérisé par le fait qu'on structure la quatrième couche isolante (18) au moyen d'une technique photochimique, de manière à former ensuite par attaque chimique, en utilisant cette couche en tant que masque, la seconde ouverture dans la seconde couche d'électrode (16′).

14. Matrice de mémoire comportant au moins quatre cellules de mémoire d'un dispositif de mémoire à semiconducteur suivant l'une des revendications 1 à 9, dans laquelle les cellules de mémoire sont disposées de la manière suivante :
- les cellules de mémoire sont disposées suivant des rangées, qui sont séparées les unes des autres par les régions isolantes (2), dans une première direction qui s'étend parallèlement à la droite géométrique entre le transistor de sélection et le condensateur,
- les cellules de mémoire dans la même rangée comprennent le transistor de sélection d'un côté fixé du condensateur,
- dans la rangée voisine, le transistor de sélection associé est situé du côté opposé du condensateur,
- les transistors de sélection sont disposés suivant une rangée, dans une seconde direction perpendiculaire à la première, et
- les sillons (7) sont disposés suivant une rangée, dans la seconde direction.

15. Dispositif de mémoire à semiconducteur suivant l'une des revendications 1 à 9, qui est câblé suivant un concept open-bitline, présentant les caractéristiques suivantes :
- dans deux plans de métallisation superposés sont disposées des lignes de transmission de mots secondaire (40) et tertiaire (41), qui s'étendent respectivement alternativement dans les premier et second plans de métallisation,
- une ligne de transmission de mots secondaire (40) et une ligne de transmission de mots tertiaire (41) sont sensiblement superposées dans les premier et second plans de métallisation et sont disposées au-dessus d'une ligne de transmission de mots primaire (4′) et passent l'une devant l'autre sans croisement, au passage dans l'autre plan de métallisation,
- la ligne de transmission de mots primaire (4′) est subdivisée en tronçons, dont chacun est relié par l'intermédiaire d'un contact (44,45) à la ligne de transmission de mots (40,41), qui s'étend au-dessus de lui dans le premier plan de métallisation.

16. Dispositif de mémoire à semiconducteurs suivant la revendication 15, caractérisé par le fait qu'au voisinage du passage sans croisement, la ligne de transmission de mots secondaire et la ligne de transmission de mots tertiaire (40, 41) s'étendent toutes deux en majeure partie dans l'un des deux plans de métallisation et qu'une ligne de sélection (46) est disposée dans l'autre plan de métallisation.
